# EUROPEAN PATENT APPLICATION

(11) **EP 2 045 842 A2**
(43) Date of publication of application: **08.04.2009**
(21) Application number: 08165495.6
(22) Date of filing: 30.09.2008
(51) Int. Cl.: H01L 27/146

(54) **Solid-state image sensing device and method for manufacturing the same**

(30) Priority: 02.10.2007 JP 2007259025
(71) Applicant: Panasonic Corporation, Kadoma-shi Osaka 571-8501 (JP)
(72) Inventor: Takeuchi, Yasuo, Osaka-shi Osaka 540-6207 (JP); Komatsu, Tomoko, Osaka-shi Osaka 540-6207 (JP); Kuroda, Masashi, Osaka-shi Osaka 540-6207 (JP); Nishio, Tetsushi, Osaka-shi Osaka 540-6207 (JP); Itoi, Kiyokazu, Osaka-shi Osaka 540-6207 (JP)
(74) Representative: Grünecker, Kinkeldey, Stockmair & Schwanhäusser Anwaltssozietät

(57) **Abstract**

A solid-state image sensing element includes an effective pixel section (17) in a central area of a light receiving surface thereof, and a ridge-shaped protruding portion (16) is provided around the effective pixel section (17). A liquid transparent adhesive (14) is applied on the effective pixel section (17), and a light transparent substrate (3) is placed thereon. The light transparent substrate (3) is in contact with the protruding portion (16), and is therefore prevented from sliding with the liquid adhesive (14) serving as a lubricant. Thus, the light transparent substrate (3) can be fixed at a predetermined position.

## Description

### BACKGROUND OF THE INVENTION

### 1. Field of the Invention

The present invention relates to a solid-state image sensing device for use in a digital camera, or the like, and a method for manufacturing the same.

### 2. Description of the Background Art

In the field of solid-state image sensing packages, the pixel size has been reduced, and therefore techniques have been researched and developed for increasing the sensitivity.

A conventional solid-state image sensing package is obtained by mounting a solid-state image sensing element on a package, and then placing a glass plate above the image sensing surface in order to protect the image sensing surface and fixing the glass plate to the package. A package of this structure is called a hollow package, where there is air between the solid-state image sensing element and the glass.

With this structure, light entering the solid-state image sensing package is reflected at the upper and lower surfaces of the glass and the surface of the solid-state image sensing element, thus losing some of the incident light. This is because there is a large refractive index difference between the air, the glass and the microlens.

In view of this, a direct-attachment package as shown in FIG. **12** is proposed in the art (for example, Japanese Laid-Open Patent Publication No. 2000-323692), where a light transparent substrate **102** provided with a group of microlenses **103** and a color filter **104** is attached to the surface of a semiconductor chip **101 b** provided with a light receiving portion **101a** with an adhesive **105** being a resin having a low refractive index. In this package, the portion corresponding to the air of a hollow package is filled with the adhesive **105.** Since the refractive index of the adhesive is greater than that of the air, the refractive index difference between the light transparent substrate **102,** the adhesive **105** and the semiconductor chip **101b** can be reduced, thereby preventing the reflection of incident light **120.**

### SUMMARY OF THE INVENTION

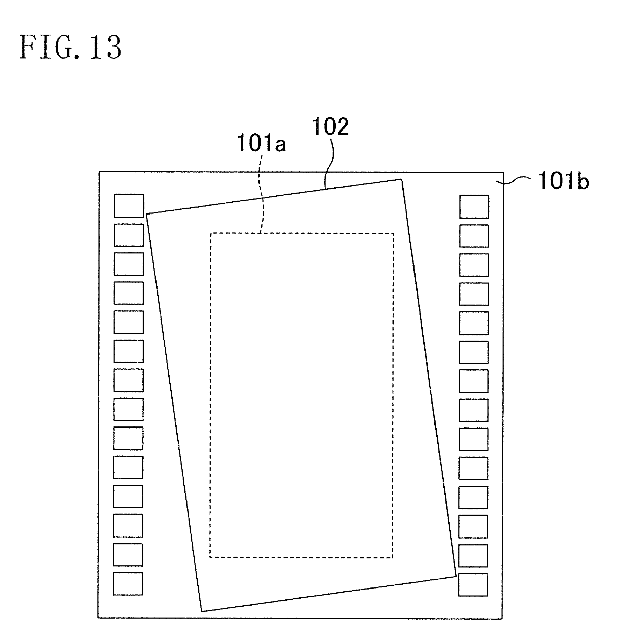

However, the structure of Japanese Laid-Open Patent Publication No. 2000-323692 has the following problem. The adhesive **105** is applied on the semiconductor chip **101b,** and then the light transparent substrate **102** is placed thereon. Even if the light receiving portion **101a** and the group of microlenses **103** are aligned with each other in advance, the light transparent substrate **102** slides out of alignment (see FIG. **13**) on the liquid adhesive **105.**

Specifically, the liquid adhesive **105** is dropped on the surface of the semiconductor chip **101b,** and then the light transparent substrate **102** is placed thereon in position. Before the placement of the light transparent substrate **102,** the adhesive **105** is yet to spread across the entire surface of the semiconductor chip **101b.** The adhesive **105** later spreads across the space between the semiconductor chip **101b** and the light transparent substrate **102** due to the weight of the light transparent substrate **102** being placed thereon. At this point, the light transparent substrate **102** may move (slide) together with the spreading (flow) of the adhesive **105.**

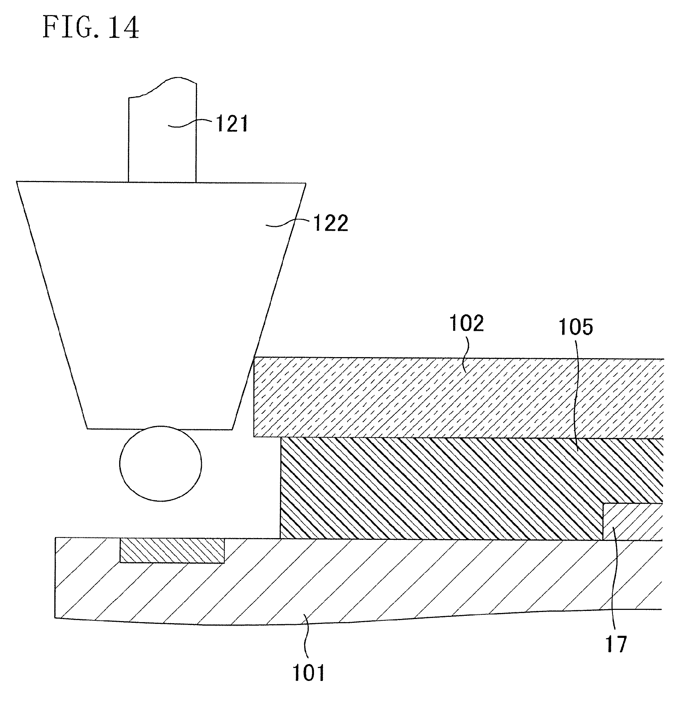

After the light transparent substrate **102** is attached, pads of the semiconductor chip **101b** and terminals of a package **110** are connected to each other by way of wire bonding. If the position of the light transparent substrate **102** is misaligned toward the pads, the light transparent substrate **102** interferes with a capillary **122** of the bonding apparatus, as shown in FIG. **14****,** whereby a wire **121** cannot be bonded.

Therefore, it is an object of the present invention to provide a solid-state image sensing device of a direct-attachment structure in which a light transparent substrate and a semiconductor substrate are directly attached to each other with a light transparent adhesive therebetween, wherein the light transparent substrate is prevented from sliding out of alignment when the light transparent substrate is attached to a solid-state image sensing element with an adhesive.

In order to achieve the object set forth above, the present invention provides a solid-state image sensing device, in which a protruding portion is provided on a light receiving surface of an image sensing element, wherein the protruding portion is in contact with a light transparent substrate.

Specifically, a solid-state image sensing device of the present invention includes a solid-state image sensing element and a light transparent substrate, wherein: the solid-state image sensing element is provided with a light receiving portion, and a light receiving surface of the solid-state image sensing element includes an effective pixel section in a central area, and includes, outside the effective pixel section, an electrode pad portion and a protruding portion protruding from the light receiving surface; the solid-state image sensing element and the light transparent substrate are attached to each other by an adhesive applied on the effective pixel section; the adhesive includes a thermosetting or photosetting resin; and the light transparent substrate is placed on at least a portion of the protruding portion. The thermosetting or photosetting resin included in the adhesive may be a hardened resin.

With such a configuration, the light transparent substrate is in contact with the protruding portion, whereby it is possible to prevent the relative position of the light transparent substrate with respect to the effective pixel section of the light transparent substrate from being shifted.

It is preferred that the friction coefficient between the protruding portion and the light transparent substrate is 0.1 or more.

It is preferred that the protruding portion has an equal protruding height across an area over which the light transparent substrate lies on the protruding portion. This means that where there are a plurality of protruding portions on which the light transparent substrate lies, the protruding portions have an equal protruding height, and where the light transparent substrate lies on a continuously extending portion, the height is the same across the continuously extending portion.

In one embodiment of the invention, at least a portion of the protruding portion lies between the effective pixel section and the electrode pad portion.

In one embodiment of the invention, the protruding portion extends in a ridge shape along the electrode pad portion between the effective pixel section and the electrode pad portion.

In one embodiment of the invention, the light transparent substrate lies on a portion of the ridge-shaped protruding portion.

In one embodiment of the invention, at least two protruding portions extend adjacent to and in parallel to each other between the effective pixel section and the electrode pad portion.

In one embodiment of the invention, there are a plurality of protruding portions each extending in a ridge shape; there are at least a set of protruding portions extending adjacent to and in parallel to each other; one of the set of protruding portions that lies closer to an edge of the solid-state image sensing element has a greater protruding height than another one of the set of protruding portions.

A method for manufacturing a solid-state image sensing device of the present invention includes the steps of: providing a solid-state image sensing element provided with a light receiving portion; forming a protruding portion protruding from a light receiving surface of the solid-state image sensing element in at least a portion of a surrounding area around the light receiving portion; applying a liquid adhesive on the light receiving portion; placing a light transparent substrate on the adhesive so that the light transparent substrate contacts at least a portion of the protruding portion; and hardening the adhesive.

### BRIEF DESCRIPTION OF THE DRAWINGS

FIG. **1** is a cross-sectional view showing a solid-state image sensing device of Embodiment 1.
FIG. **2** is a plan view showing a solid-state image sensing device of Embodiment 1.
FIG. **3** is a cross-sectional view showing a solid-state image sensing package of Embodiment 1.
FIGs. **4A** to **4D** are cross-sectional views each showing a shape of a protruding portion.
FIGs. **5A** to **5C** are cross-sectional views showing a protruding portion of Embodiment 2 and those of variations of Embodiment 2.
FIG. **6** is a cross-sectional view showing how a light transparent substrate is placed according to Variation 1 of Embodiment 2.
FIG. **7** is a plan view showing a solid-state image sensing device of an alternative embodiment of the present invention.
FIGs. **8A** to **8C** are cross-sectional views showing protruding portions of alternative embodiments of the present invention.
FIG. **9** shows a flow of a process for manufacturing a solid-state image sensing device of Embodiment 1.
FIG. **10** is a plan view showing a wafer with an array of solid-state image sensing elements thereon.
FIG. **11** is a plan view showing a solid-state image sensing device of an alternative embodiment of the present invention.
FIG. **12** is a cross-sectional view showing a conventional solid-state image sensing device.
FIG. **13** is a plan view showing a conventional solid-state image sensing device.
FIG. **14** is a cross-sectional view showing a conventional solid-state image sensing device during a bonding process.

### DETAILED DESCRIPTION OF THE PREFERRED EMBODIMENTS

Solid-state image sensing devices according to preferred embodiments of the present invention will now be described with reference to the drawings.

### EMBODIMENT 1

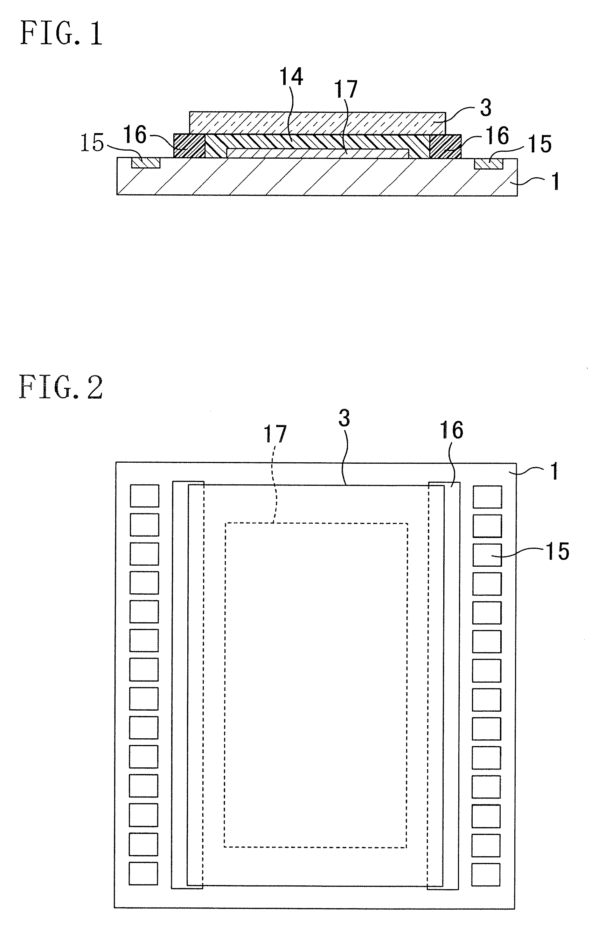

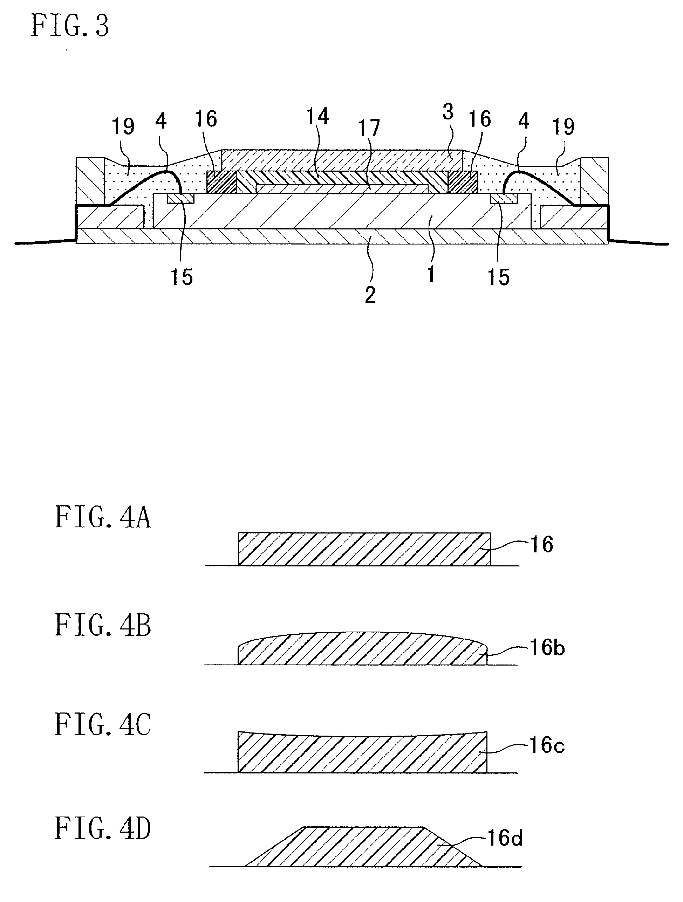

FIG. **1** is a cross-sectional view showing a solid-state image sensing device of Embodiment 1, and FIG. **2** is a plan view thereof. FIG. **3** is a cross-sectional view showing a solid-state image sensing package including therein a solid-state image sensing device of the present embodiment.

The solid-state image sensing device of the present embodiment includes a solid-state image sensing element **1** provided with a light receiving portion, and a light transparent substrate **3** attached to the light receiving surface of the solid-state image sensing element **1** via a transparent adhesive **14.** The solid-state image sensing element **1** is in a rectangular plate shape, and a rectangular effective pixel section **17** being a part of the light receiving portion is provided in a central area of the light receiving surface. On the light receiving surface of the solid-state image sensing element **1,** a row of electrode pad portions **15** extends on the outer side of one side of the effective pixel section **17** and another row on the outer side of another, opposing side of the effective pixel section **17.** Between the effective pixel section **17** and each row of the electrode pad portions **15,** there is a ridge-shaped protruding portion **16** extending in parallel to the row of the electrode pad portions **15.**

The effective pixel section **17** includes an image sensing portion of the solid-state image sensing element **1,** and microlenses (on-chip microlenses) provided thereon.

The adhesive **14** is applied on the effective pixel section **17,** and the light transparent substrate **3** is placed thereon. Two opposing sides of the rectangular light transparent substrate **3** lie on the protruding portions **16** and **16.**

The solid-state image sensing device of the present embodiment is mounted on a package substrate **2,** and the electrode pad portions **15** are electrically connected to lead terminals 5 exposed on the outside of the package substrate **2** via wires **4,** thus forming a solid-state image sensing package.

The light transparent substrate **3** may be of an inorganic material (a borosilicate glass, a quartz glass, etc.), an organic material (an acrylic resin, a polycarbonate resin, an olefin resin, etc.), or a hybrid thereof.

Thus, it is required that the light transparent substrate **3** has a high visible light transmittance, can be processed into a flat (plate) shape, and can be bonded by the adhesive **14** to be described below. Where an organic material is used for the light transparent substrate **3,** if the anti-shock property is poor, it is more preferred to use a hybrid material containing an inorganic material added as a filler. In this case, the transparent substrate **3** may become translucent substrate. The use of a borosilicate glass as the light transparent substrate **3** is more advantageous in view of the possibility of handling scratches, the anti-solvent property during manufacture, and the cost. The use of quartz as the light transparent substrate **3** is also more advantageous in view of the possibility of handling scratches, and the anti-solvent property during manufacture.

With the conventional hollow package, light entering the solid-state image sensing element is reflected at the upper and lower surfaces of the glass and the surface of the semiconductor substrate, thus losing some of the incident light. This is because of the large refractive index difference between the air, the glass and the microlenses.

In contrast, the solid-state image sensing device of the present embodiment has a structure in which the light transparent substrate **3** is directly attached to the light receiving portion with the adhesive **14** therebetween. Then, the portion corresponding to the air in a conventional structure is filled with the adhesive **14** being used for attaching the light transparent substrate **3,** and the adhesive **14** has a greater refractive index than that of air. As a result, it is possible to reduce the refractive index difference between the light transparent substrate **3,** the adhesive **14** and the solid-state image sensing element **1,** thereby reducing the loss of light due to reflections.

Moreover, the protruding portions **16** are formed on the solid-state image sensing element **1** in order to prevent the light transparent substrate **3** from sliding when the light transparent substrate **3** is placed on the adhesive **14** applied on the solid-state image sensing element **1.** The provision of the protruding portions **16** prevents the light transparent substrate **3** from sliding as follows.

Where only the liquid adhesive **14** is present between the light transparent substrate **3** and the solid-state image sensing element **1,** with no protruding portions **16** therebetween, the adhesive **14** serves as a lubricant, and the friction between the light transparent substrate **3** and the solid-state image sensing element **1** is a fluid friction, whereby the friction resistance is equal to the viscosity resistance of the adhesive **14.** In this state, the friction coefficient is less than 0.01 based on the Stribeck curve, and the light transparent substrate **3** slides easily even with a small horizontal force.

In the present embodiment, the light transparent substrate **3** is in contact with the solid protruding portions **16,** and the friction therebetween is believed to be a dry friction or a boundary friction, whereby the friction coefficient is 0.1 or more based on the Stribeck curve, or 0.2 or more if the protruding portion **16** is formed by a resin material as shown below. Since there is a sufficient frictional force between the light transparent substrate **3** and the protruding portions **16,** the light transparent substrate **3** will not slide even if there is some horizontal force acting on the light transparent substrate **3** during manufacture. If the light transparent substrate **3** can be attached and fixed to the solid-state image sensing element **1** while being aligned thereto, the microlens will not be misaligned, and it is possible to avoid a problem in the wire bonding step as shown in FIG. **14****.**

The protruding portions **16** are formed by a resin, for example, and the resin material may be a common positive or negative photosensitive resin such as an acrylic resin, a styrene resin or a phenol novolak resin, or an organic resin such as a urethane resin, an epoxy resin or a styrene resin. The patterning process for forming the protruding portions **16** is performed by a photolithography when using a photosensitive resin, and by a liftoff process otherwise.

The main component of the light transparent adhesive **14** is a thermosetting or photosetting resin. Therefore, the adhesive **14** is a liquid upon application, but becomes a solid when a heat or light is applied thereto after the light transparent substrate **3** is placed thereon.

In the present embodiment, each protruding portion **16** is provided between the effective pixel section **17** and the electrode pad portions **15,** with its width and height being precisely controlled to intended values. If the width of the protruding portion **16** is greater than the intended value, there will be a shorter distance between the protruding portion **16** and the effective pixel section **17** or the electrode pad portions **15,** thereby resulting in shadows and color irregularities (an image defect). If the height of the protruding portion **16** varies, the flatness of the light transparent substrate **3** to be placed thereon will be poor (i.e., it will be slanted with respect to the plane of the effective pixel section **17),** thereby resulting in an image defect such as moiré. Color irregularities refer to an image defect as follows. When light enters the effective pixel section **17** of the solid-state image sensing device from an oblique direction, the light is blocked by the protruding portion **16,** and the portion of the image near the light-blocking protruding portion **16** appears darker, resulting in a brightness difference between such a portion and other portions, which is seen as irregularities.

In the present embodiment, since each protruding portion **16** is provided between the effective pixel section **17** and the electrode pad portions **15,** with its width and height being precisely controlled to intended values, it is possible to prevent image defects such as color irregularities and moiré.

If the protruding portion **16** has a larger width than the intended value, the wire bonding strength is lowered, thus resulting in a defect where the wires **4** cannot be connected to the electrode pads. In the present embodiment, it is possible to prevent such a defect.

In view of the precision or the process of patterning, it is more preferred that a photosensitive resin (positive or negative) is used for the protruding portions **16.** Then, the protruding portions **16** can be produced with precisely-controlled width and height. Thus, the light transparent substrate **3** can be attached to a predetermined position while being flat, and it is possible to prevent the weakening of the wire bonding without affecting the image quality (i.e., without moiré or color irregularities).

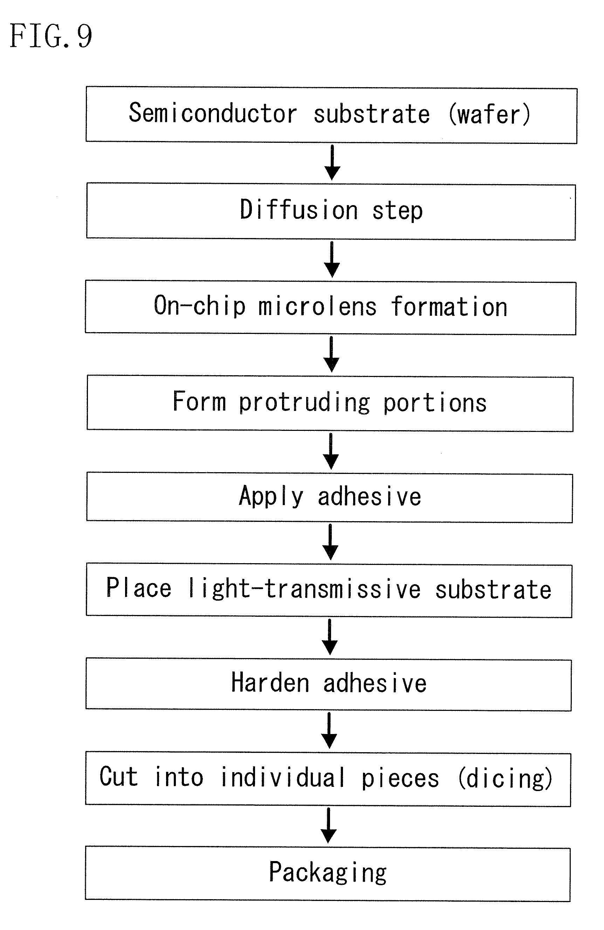

If the same resin as the photosensitive resin used in the diffusion step or the on-chip microlens formation step of FIG. **9** to be described later is selected from among those resins mentioned above, it is possible to reduce the total number of materials to be used, thus facilitating the material management.

The material of the protruding portions **16** may be a material obtained by adding about 0% to about 80% of a spherical, fibrous or indeterminate-form filler made of a resin, a glass or quartz to a binder resin. By using a resin material containing a filler therein, it is possible to increase the mechanical strength of the protruding portions **16.**

If the thickness of the resin material of the protruding portions **16** is about 1 to about 50 µm, a film of the resin material can be formed in a single rotation application process. For larger thicknesses, the rotation application can be performed a plurality of times. With rotation application, the upper surface of the semiconductor substrate and the upper surface of the obtained film can be made substantially parallel to each other. Particularly, where a photosensitive resin is used to form the protruding portions **16,** a film is formed by that photosensitive resin, and a photolithography process is performed to harden the portions to be the protruding portions **16** while peeling off unnecessary portions. In such a case, an apparatus for manufacturing the solid-state image sensing element **1** can be used as it is, and the production can be done at low cost. For example, the speed of the rotation application is about 1000 rpm to about 3000 rpm, the prebake temperature is about 80°C to about 100°C, the exposure time is about 100 ms to about 1000 ms, and the developer is an alkali developer or an organic developer. Then, the postbaking process is performed at a temperature of about 200°C to about 220°C.

Where the protruding portion **16** is formed by a resin that can be etched, a film of the resin is formed, and a mask is formed thereon, which selectively covers portions to be the protruding portions and has openings in other portions. Then, an etching process is performed to remove unnecessary portions while selectively leaving the portions to be the protruding portions **16.** In this case, there is a greater variety of choice of resin materials.

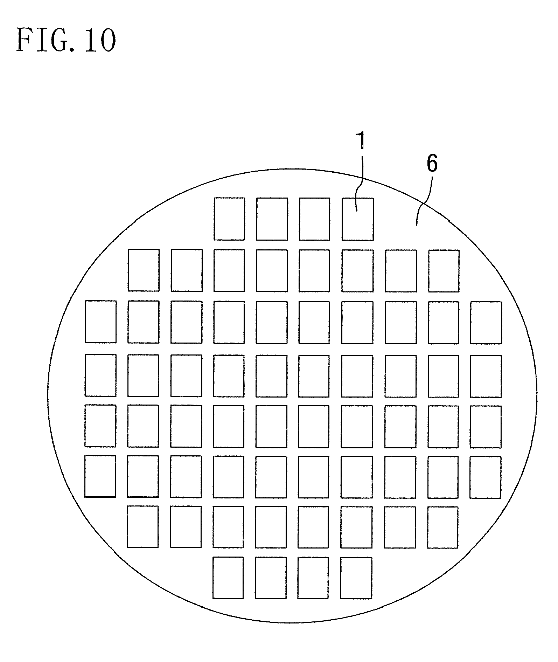

The solid-state image sensing device of the present embodiment is produced by a process flow as shown in FIG. **9****.** First, a semiconductor substrate (wafer) is provided, and a plurality of solid-state image sensing elements **1** are made in the semiconductor substrate through a diffusion step. FIG. **10** shows the solid-state image sensing elements **1** made in a wafer **6.** Then, in an on-chip microlens formation step, microlenses are formed on the chip (the solid-state image sensing element). Then, the protruding portions **16** are formed around the light receiving portion as described above. Then, the liquid adhesive **14** is applied on the light receiving portion. Then, the light transparent substrate **3** is placed on the adhesive **14,** with a peripheral portion of the light transparent substrate **3** being in contact with the protruding portions **16.** Before the light transparent substrate **3** contacts the protruding portions **16,** the light transparent substrate **3** is supported by a support arm, and the relative position of the light transparent substrate **3** with respect to the solid-state image sensing element **1** is precisely maintained. Then, the adhesive **14** is hardened by heat or light. Up to the step of hardening the adhesive **14** is a so-called "wafer process", wherein the semiconductor substrate is handled in the form of the wafer **6.** Then, the wafer **6** is diced into individual solid-state image sensing devices, and each diced solid-state image sensing device as shown in FIG. **1** is mounted on the package substrate **2.**

In the present embodiment, the protruding portions **16** are formed to a predetermined height, the light transparent substrate **3** is placed on the adhesive **14** applied on the effective pixel section **17,** and the light transparent substrate **3** is pressed down until the light transparent substrate **3** is in contact with the upper surface of the protruding portions **16** so as to spread the adhesive **14,** after which the adhesive **14** is hardened. Since the protruding portions **16** are higher than the light receiving surface of the solid-state image sensing element **1,** the solid-state image sensing element **1** can be prevented from being damaged during the pressing process.

Since the thickness of the adhesive **14** influences the light transmittance property, it is very important to realize a thickness as intended. With the present configuration, the interval between the solid-state image sensing element **1** and the light transparent substrate **3,** i.e., the thickness of the adhesive **14,** can be defined by the height of the protruding portions **16.** There are two protruding portions **16** and **16** provided so as to interpose the effective pixel section **17** therebetween, and the protruding portions 16 and **16** have an equal height from the light receiving surface. Thus, the light transparent adhesive **14** can be formed to an intended thickness.

In the present embodiment, since the light transparent substrate **3** is attached to a predetermined position in the presence of the protruding portions **16,** it is possible to eliminate the incidence of unnecessary light on the effective pixel section **17** (particularly, light coming from an oblique direction). Moreover, by defining the height of the two protruding portions **16** and **16,** the light transparent substrate **3** can be attached while being flat. Since the two protruding portions **16** and **16** have an equal height, the light receiving surface of the solid-state image sensing element **1** and the light transparent substrate **3** can easily be arranged parallel to each other by placing the light transparent substrate **3** on both of the two protruding portions **16** and **16.**

While the light transparent substrate **3** is attached to the surface of the solid-state image sensing element **1** via the adhesive **14,** the adhesive **14** has a larger refractive index than that of the air. Thus, it is possible to reduce the refractive index difference between the light transparent substrate **3,** the adhesive **14** and the solid-state image sensing element **1,** thereby reducing the loss of light due to reflections. As a result, it is possible to obtain an image with a high sensitivity (with reduced reflection loss) without affecting the image quality (i.e., without moiré or color irregularities).

Since the protruding portions **16** each extend between a row of electrode pads and the effective pixel section **17,** the adhesive **14** is blocked by the protruding portions **16** serving as a dam and will not reach the electrode pad portions **15,** whereby the electrical connection between the wires can the electrode pad portions **15** is reliably made by wire bonding.

When the adhesive **14** is hardened, the adhesive **14** penetrates between the light transparent substrate 3 and the protruding portions **16,** thereby enhancing the adhesion strength therebetween.

Next, variations of the shape of the protruding portions **16** will be described.

FIGs. **4A** to **4D** are each a cross-sectional view of the protruding portion **16,** taken in a direction perpendicular to the row of electrode pads.

FIG. **4A** shows the protruding portion **16** as described above, whose upper surface is flat and parallel to the light receiving surface of the solid-state image sensing element **1.** FIG. **4B** shows a protruding portion **16b** of Variation 1 having an upwardly-protruding upper surface. FIG. **4C** shows a protruding portion **16c** of Variation 2 having a depressed upper surface. FIG. **4D** shows a protruding portion **16d** of Variation 3 whose upper surface is flat and parallel to the light receiving surface of the solid-state image sensing element **1,** wherein the protruding portion **16d** has a trapezoidal cross section, with the lower surface being larger than the upper surface.

The protruding portion **16, 16b, 16c** or **16d** is provided for the purpose of suppressing the sliding of the light transparent substrate **3** when the light transparent substrate **3** is attached, and the sliding of the light transparent substrate **3** can be controlled by changing the shape of the upper surface of the protruding portion **16, 16b, 16c** or **16d,** i.e., by changing the contact area between the light transparent substrate 3 and the protruding portion **16, 16b, 16c** or **16d.**

Where the upper surface of the protruding portion **16** or **16d** is parallel to the light receiving surface, the sliding of the light transparent substrate **3** can be controlled also by changing the width of the upper surface. Because of the contact area between the light transparent substrate **3** and the protruding portion, the most preferred is the upper surface being parallel to the light receiving surface, the second most preferred is the upper surface being depressed, and the third most preferred is the upper surface being upwardly protruding.

Where the upper surface of the protruding portions is parallel to the light receiving surface (e.g., the protruding portion **16** or **16d**), the distance between the lower surface of the light transparent substrate **3** and the light receiving surface is constant, irrespective of the position on the protruding portions **16** and **16d** at which the light transparent substrate **3** lies. This provides a further advantage of a large alignment margin for placing the light transparent substrate **3.** Moreover, if a load is applied from above the light transparent substrate **3** after the light transparent substrate **3** is attached, the load is applied entirely across the protruding portion **16** or **16d,** whereby deformation is unlikely to occur.

Where the upper surface of the protruding portions is upwardly protruding (e.g., the protruding portion **16b),** since the protruding portion **16b** has no corners, it is possible to suppress the generation of chips due to chipping/shaving of the protruding portion **16b** as the light transparent substrate **3** contacts the protruding portion **16b.**

Where the upper surface of the protruding portions is depressed (e.g., the protruding portion **16c**), the adhesive **14** permeates also into the gap between the light transparent substrate **3** and the protruding portion **16c** during the attachment of the light transparent substrate **3,** and the adhesive **14** can partly be pushed out of the protruding portion **16c.** This varies the contact area between the light transparent substrate 3 and the protruding portion **16c,** whereby it is possible to control the sliding of the light transparent substrate **3.**

Where the protruding portions are tapered (into a trapezoidal shape) as shown in FIG. **4D****,** the flowability of the adhesive **14** is improved, thereby preventing a gap from being produced between the protruding portion **16d** and the adhesive **14.**

### EMBODIMENT 2

A solid-state image sensing device of Embodiment 2 is the same as that of Embodiment 1, except for the protruding portions, which will now be described below.

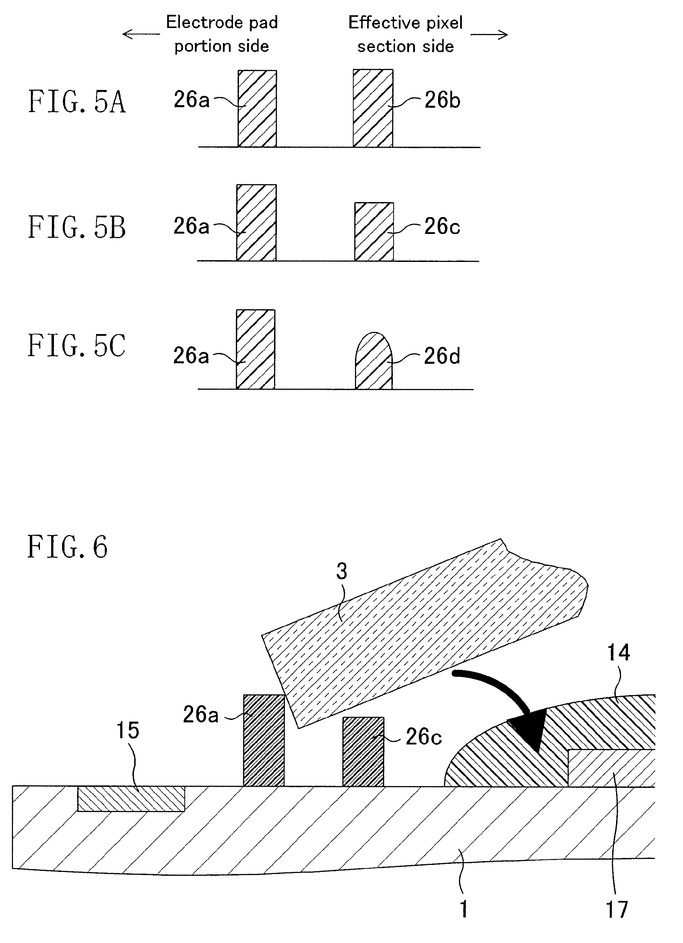

FIG. **5A** is a cross-sectional view showing protruding portions **26a** and **26b** of a solid-state image sensing device of Embodiment 2, FIG. **5B** is a cross-sectional view showing protruding portions **26a** and **26c** of Variation 1 of Embodiment 2, and FIG. **5C** is a cross-sectional view showing protruding portions **26a** and **26d** of Variation 2 of Embodiment 2. In the present embodiment, two protruding portions **26a** and **26b** are provided between one side of the effective pixel section **17** and one row of electrode pad portions **15.**

In the present embodiment, the two protruding portions **26a** and **26b** formed along one side of the solid-state image sensing device have an equal height. In Variation 1 shown in FIG. **5B****,** a protruding portion **26c** on the side of the effective pixel section **17** is lower than the protruding portion **26a** on the side of the electrode pad portions **15.** In Variation 2 shown in FIG. **5C****,** a protruding portion **26d** on the side of the effective pixel section **17** is lower than the protruding portion **26a** on the side of the electrode pad portions **15,** and the upper portion of the protruding portion **26d** on the side of the effective pixel section **17** is rounded off so as to have a semicircular cross section.

In the present embodiment, with the two protruding portions **26a** and **26b** having the same height, a portion of the adhesive **14** that is pushed over the first protruding portion **26b** can be blocked by the second protruding portion **26a.**

The arrangement where one of two adjacent protruding portions (the protruding portion **26a**) has a different height from that of the other protruding portion **26c** or **26d** as in Variation 1 or 2 is advantageous in that the light transparent substrate **3** can first be placed at an oblique angle with respect to the horizontal plane with one side thereof lying on the protruding portion **26c** on the side of the effective pixel section **17,** and then be brought down to a horizontal position for attachment, as shown in FIG. **6****.** With the outer protruding portion **26a** being higher, it is possible to more reliably prevent the light transparent substrate **3** from sliding sideways when the light transparent substrate **3** is brought down to a horizontal position.

Where there are two (or more) protruding portions with their upper surfaces being parallel, it is possible to more reliably prevent a portion of the adhesive that is pushed over one protruding portion from reaching the pads, and the sliding of the light transparent substrate is more reliably blocked, whereby it is possible to increase the contact area between the light transparent substrate and the protruding portions. In other words, even if some adhesive is partly pushed over the first protruding portion, the amount of such adhesive is small, which will be reliably prevented by the second protruding portion from leaking to the outside. Where there are two protruding portions with the same upper portion width, the contact area with the light transparent substrate is doubled as compared with a case where there is only one protruding portion, thereby increasing the effect of preventing the sliding of the light transparent substrate.

Where there are two ridge-shaped protruding portions with different heights (e.g., the protruding portions **26a** and **26c**), the light transparent substrate **3** can first be placed on the adhesive **14** with one side of the light transparent substrate **3** lying on the protruding portion **26c** on the side of the effective pixel section **17,** as shown in FIG. **6****,** wherein since the protruding portion **26a** on the side of the electrode pad portions **15** has a greater height and thus can be used as a stopper for the light transparent substrate **3** for the purpose of alignment.

As described above, where there are a plurality (two) of protruding portions (e.g., the protruding portions **26a** and **26b, 26c** or **26d**) formed along one side of the solid-state image sensing element **1,** even if the adhesive **14** is pushed over the protruding portion **26b, 26c** or **26d** on the side of the effective pixel section **17** and leaks toward the electrode pad portions **15,** the adhesive **14** can be prevented from reaching the electrode pad portions **15.**

### (Alternative Embodiments)

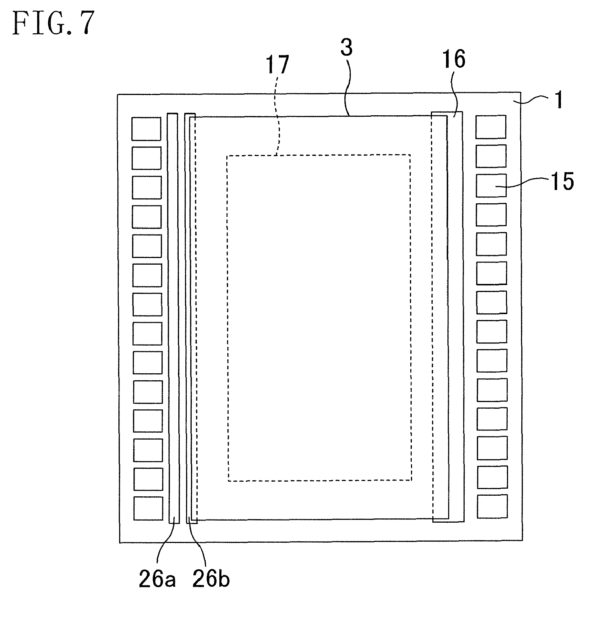

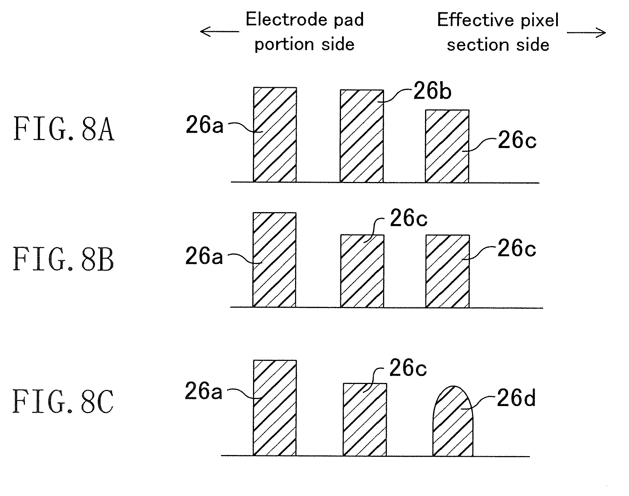

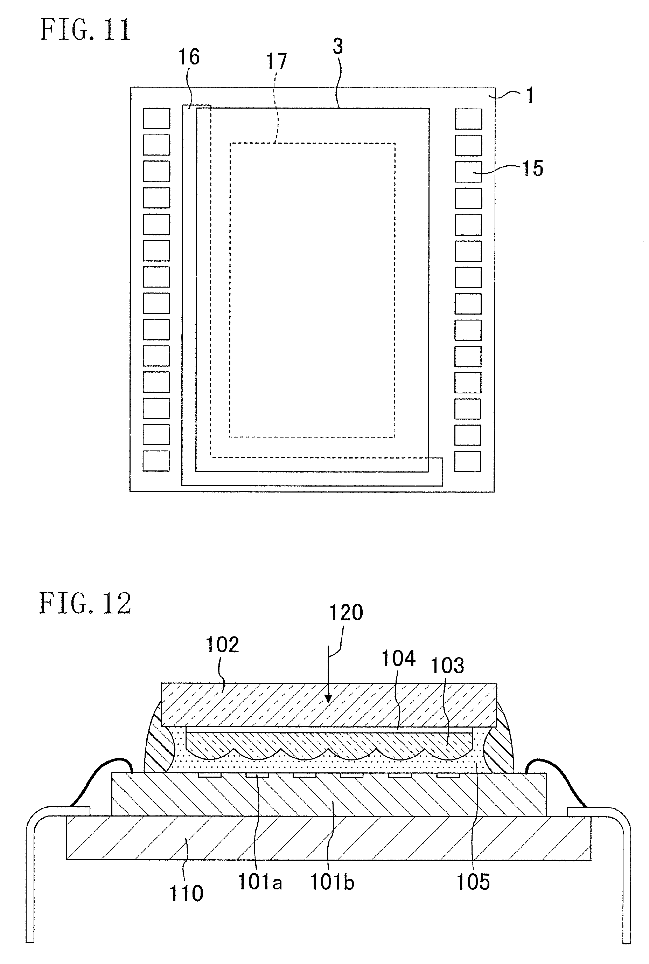

The particular embodiments set forth above are merely illustrative, and the present invention is not limited to those particular embodiments. For example, FIG. **11** shows an alternative embodiment of an L-shaped protruding portion. FIG. **7** shows an alternative embodiment, being a combination of Embodiment 1 and Embodiment 2, wherein a single ridge-shaped protruding portion **16** is provided along one side of the solid-state image sensing element **1,** while two ridge-shaped protruding portions **26a** and **26b** are formed on the opposite side. FIGs. **8A** to **8C** each show an alternative embodiment, wherein there are three protruding portions **26a, 26b** and **26c** provided next to one another between the electrode pad portions **15** and the effective pixel section **17.**

In the embodiments above, electrode pad portions are formed along two sides of the solid-state image sensing element, and the protruding portions are accordingly formed along two sides of the solid-state image sensing element. Where electrode pad portions are formed along three or four sides of the solid-state image sensing element, the protruding portions may be formed accordingly. The position of the protruding portion is not limited to between the effective pixel section and the electrode pad portions, but may alternatively be along a side where the electrode pad portions are not formed outside the effective pixel section or may be further outside the electrode pad portions.

The shape of the protruding portion is not limited to a ridge shape, but may alternatively be a dotted shape or a string or strings of dots.

The placement of the light transparent substrate on the protruding portions may be varied on the order of µm or more. Where the interval between the protruding portions is the same as the width of the light transparent substrate, the light transparent substrate being shifted may hang over a protruding portion. If the surrounding space is filled with an encapsulation resin, the encapsulation resin may not reach the corner between the protruding portion and a portion of the light transparent substrate hanging over the protruding portion, thus resulting in incomplete filling of an encapsulation resin. Where the interval between the protruding portions is sufficiently larger than the light transparent substrate, the light transparent substrate will not lie over a protruding portion even if the placement of the light transparent substrate is shifted by some µm, thus preventing an incomplete filling of an encapsulation resin.

The solid-state image sensing device of the present invention includes protruding portions provided on the light receiving surface of the image sensing element, and the light transparent substrate is placed on the protruding portions. Therefore, there is a frictional force between the protruding portions and the light transparent substrate. Thus, when the light transparent substrate is placed on a thermosetting or photosetting liquid adhesive, the light transparent substrate is prevented from sliding with the adhesive serving as a lubricant.

As described above, the solid-state image sensing device of the present invention, in which the light transparent substrate is placed with a high precision, is useful in applications such as digital cameras.

## Claims

1. A solid-state image sensing device, comprising a solid-state image sensing element and a light transparent substrate, wherein:
the solid-state image sensing element is provided with a light receiving portion, and a light receiving surface of the solid-state image sensing element includes an effective pixel section in a central area, and includes, outside the effective pixel section, an electrode pad portion and a protruding portion protruding from the light receiving surface;
the solid-state image sensing element and the light transparent substrate are attached to each other by an adhesive applied on the effective pixel section;
the adhesive includes a thermosetting or photosetting resin; and
the light transparent substrate is placed on at least a portion of the protruding portion.

2. The solid-state image sensing device of claim 1, wherein the protruding portion has an equal protruding height across an area over which the light transparent substrate lies on the protruding portion.

3. The solid-state image sensing device of claim 1, wherein at least a portion of the protruding portion lies between the effective pixel section and the electrode pad portion.

4. The solid-state image sensing device of claim 3, wherein the protruding portion extends in a ridge shape along the electrode pad portion between the effective pixel section and the electrode pad portion.

5. The solid-state image sensing device of claim 4, wherein the light transparent substrate lies on a portion of the ridge-shaped protruding portion.

6. The solid-state image sensing device of claim 4, wherein at least two protruding portions extend adjacent to and in parallel to each other between the effective pixel section and the electrode pad portion.

7. The solid-state image sensing device of claim 1, wherein:
there are a plurality of protruding portions each extending in a ridge shape;
there are at least a set of protruding portions extending adjacent to and in parallel to each other;
one of the set of protruding portions that lies closer to an edge of the solid-state image sensing element has a greater protruding height than another one of the set of protruding portions.

8. A method for manufacturing a solid-state image sensing device, comprising the steps of:
providing a solid-state image sensing element provided with a light receiving portion;
forming a protruding portion protruding from a light receiving surface of the solid-state image sensing element in at least a portion of a surrounding area around the light receiving portion;
applying a liquid adhesive on the light receiving portion;
placing a light transparent substrate on the adhesive so that the light transparent substrate contacts at least a portion of the protruding portion; and
hardening the adhesive.
